# EUROPEAN PATENT SPECIFICATION

(11) **EP 3 169 136 B1**
(45) Date of publication and mention of the grant of the patent: **03.10.2018**
(21) Application number: 16754741.3
(22) Date of filing: 03.02.2016
(51) Int. Cl.: H04W 88/08

(54) **DATA PROCESSING SYSTEM**
DATENVERARBEITUNGSSYSTEM
SYSTÈME DE TRAITEMENT DE DONNÉES

(30) Priority: 28.02.2015 CN 201510091317
(43) Date of publication of application: 17.05.2017
(73) Proprietor: HUAWEI TECHNOLOGIES CO., LTD., Shenzhen Guangdong 518129 (CN)
(72) Inventor: ZHAO, Xingshan, Shenzhen Guangdong 518129 (CN); HUANG, Weihua, Shenzhen Guangdong 518129 (CN); PAN, Baoliang, Shenzhen Guangdong 518129 (CN)
(74) Representative: Maiwald Patent- und Rechtsanwaltsgesellschaft mbH
(86) International application number: PCT/CN2016/073303
(87) International publication number: WO 2016/134632

(56) References cited:
- WO-A1-2009/065255
- CN-A- 1 434 361
- CN-A- 103 870 390
- CN-A- 104 735 824
- US-A1- 2003 145 243
- US-A1- 2011 102 078
- US-A1- 2012 079 355

## Description

### TECHNICAL FIELD

The present invention relates to the data processing field, and in particular, to a data processing system.

### BACKGROUND

After receiving a high frequency signal by using an antenna of a receiving device, a base station needs to convert the high frequency signal to an intermediate frequency signal, and then processes service data in the intermediate frequency signal, so that processed service data can meet a system requirement of the receiving device.

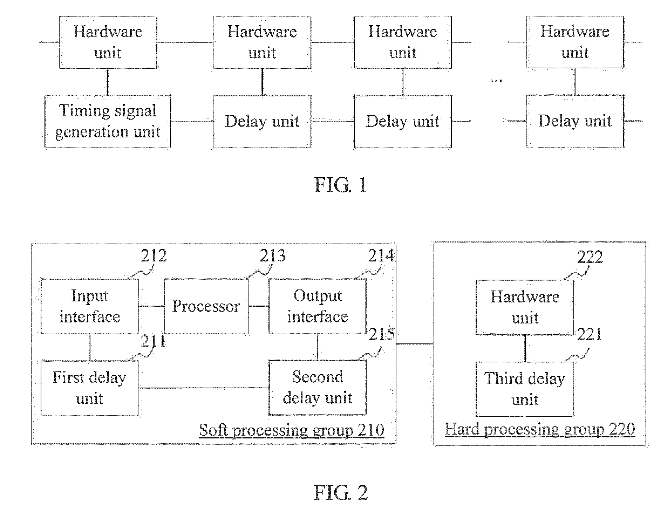

In related technologies, a hardware system is used to process service data. Referring to a structural block diagram of a hardware system shown in FIG. 1, the hardware system includes a timing signal generation unit, N hardware units, and (N-1) delay units. The timing signal generation unit is hardwired to both the 1^{st} hardware unit and the 1^{st} delay unit. The i^{th} hardware unit is hardwired to the (i+1)^{th} hardware unit. The i^{th} delay unit is hardwired to both the (i+1)^{th} hardware unit and the (i+1)^{th} delay unit. N and i are positive integers, and N > i > 1.

When service data is being processed, the timing signal generation unit sends a generated first timing signal to the 1^{st} hardware unit and the 1^{st} delay unit by using a hardwire. The 1^{st} delay unit delays the timing signal, and sends an obtained second timing signal to the 2^{nd} hardware unit and the 2^{nd} delay unit by using a hardwire. The 1^{st} hardware unit processes original service data according to obtained control information, and under triggering of the first timing signal, sends obtained first service data and the control information to the 2^{nd} hardware unit by using a hardwire. The 2^{nd} hardware unit processes the first service data according to the control information, and sends obtained second service data to the 3^{rd} hardware unit by using a hardwire under triggering of the second timing signal. By that analogy, when the N^{th} hardware unit outputs n^{th} service data under triggering of an (N-1)^{th} delay signal, the processing procedure ends.

A hardware unit has a limited service data processing capability. Therefore, when large quantities of operations are required for service data, efficiency of processing the service data by using a hardware system is relatively low.

WO2009065255 discloses a signal processing method to be implemented on a CDMA base station. In particular said document discloses a BTS system consisting of a timing advance unit for generating a signal ahead of the time when it should be transmitted from an antenna of a local cell by a predetermined timing advance value; a splitter for splitting the signal generated by the timing advance unit into two branches; a delay unit for delaying a first branch of split signals by the predetermined timing advance value; and a radio processing unit for receiving both the first delayed branch of split signals and a second non-delayed branch of split signals, performing the same Digital-Analog conversion and RF processing to the first and the second branches of split signals respectively, and then outputting the processed first delayed branch of split signals for the usage of the local cell, and outputting the processed second non-delayed branch of split signals to a local unit of an optical repeater to be transmitted for the usage of a remote cell.

US2011102078 discloses a device for processing an input signal, said device comprising a delay unit for delaying the input signal by a predefined delay time before sending the input signal to a phase shifting unit and to a plurality of mixer units. The device may also comprise a plurality of parallel processing paths.

### SUMMARY

The invention is set out in the appended set of claims. The embodiments and/or examples of the following description which are not covered by the appended claims are considered as not being part of the present invention.

To resolve a problem of low service data processing efficiency of a hardware system resulting from a relatively weak processing capability of a hardware unit, embodiments of the present invention provide a data processing system. The technical solutions are as follows:
According to a first aspect, a data processing system is provided, where the system includes N cascaded processing groups, the N cascaded processing groups include A soft processing groups and B hard processing groups, and A + B = N, where
each soft processing group includes a first delay unit, an input interface, a processor, an output interface, and a second delay unit; the first delay unit is hardwired to both the input interface and the second delay unit; the processor is electrically connected to both the input interface and the output interface; the second delay unit is hardwired to the output interface; the first delay unit is configured to send a first timing signal to the input interface and the second delay unit; the second delay unit is configured to: delay the first timing signal that is from the first delay unit, to obtain a second timing signal, and send the second timing signal to the output interface; the input interface is configured to: obtain service data, control information, and the first timing signal, combine the service data and the control information under triggering of the first timing signal to obtain a first data packet, and send the first data packet to the processor; the processor is configured to: process the service data according to the control information in the first data packet, and send an obtained second data packet to the output interface, where the second data packet includes the processed service data; and the output interface is configured to: parse the second data packet to obtain the processed service data, obtain the second timing signal, and output the processed service data under triggering of the second timing signal;
each hard processing group includes a third delay unit and a hardware unit, the third delay unit is hardwired to the hardware unit, and the third delay unit is configured to send a third timing signal to the hardware unit; and
N, A, and B are all positive integers.

In a first possible implementation manner of the first aspect, when the i^{th} processing group is a soft processing group and the (i+1)^{th} processing group is a hard processing group, an output interface in the i^{th} processing group is hardwired to a hardware unit in the (i+1)^{th} processing group, and a second delay unit in the i^{th} processing group is hardwired to a third delay unit in the (i+1)^{th} processing group, where i is a positive integer.

In a second possible implementation manner of the first aspect, when the i^{th} processing group is a soft processing group and the (i+1)^{th} processing group is a soft processing group, an output interface in the i^{th} processing group is hardwired to an input interface in the (i+1)^{th} processing group, and a second delay unit in the i^{th} processing group is hardwired to a first delay unit in the (i+1)^{th} processing group, where i is a positive integer.

According to the second possible implementation manner of the first aspect, in a third possible implementation manner of the first aspect, the output interface in the i^{th} processing group is hardwired to a processor in the (i+1)^{th} processing group, the second delay unit in the i^{th} processing group is hardwired to the processor in the (i+1)^{th} processing group, and the processor in the (i+1)^{th} processing group is configured to: generate control information according to a control signal from the output interface in the i^{th} processing group and a second timing signal from the second delay unit in the i^{th} processing group, and process service data from the output interface in the i^{th} processing group according to the control information.

In a fourth possible implementation manner of the first aspect, when the i^{th} processing group is a hard processing group and the (i+1)^{th} processing group is a hard processing group, a hardware unit in the i^{th} processing group is hardwired to a hardware unit in the (i+1)^{th} processing group, and a third delay unit in the i^{th} processing group is hardwired to a third delay unit in the (i+1)^{th} processing group, where i is a positive integer.

In a fifth possible implementation manner of the first aspect, when the i^{th} processing group is a hard processing group and the (i+1)^{th} processing group is a soft processing group, a hardware unit in the i^{th} processing group is hardwired to an input interface in the (i+1)^{th} processing group, and a third delay unit in the i^{th} processing group is hardwired to a first delay unit in the (i+1)^{th} processing group, where i is a positive integer.

According to the fifth possible implementation manner of the first aspect, in a sixth possible implementation manner of the first aspect, the hardware unit in the i^{th} processing group is hardwired to a processor in the (i+1)^{th} processing group, the third delay unit in the i^{th} processing group is hardwired to the processor in the (i+1)^{th} processing group, and the processor in the (i+1)^{th} processing group is configured to: generate control information according to a control signal from the hardware unit in the i^{th} processing group and a third timing signal from the third delay unit in the i^{th} processing group, and process service data from the hardware unit in the i^{th} processing group according to the control information.

According to the first aspect, the first possible implementation manner of the first aspect, the second possible implementation manner of the first aspect, the third possible implementation manner of the first aspect, the fourth possible implementation manner of the first aspect, the fifth possible implementation manner of the first aspect, or the sixth possible implementation manner of the first aspect, in a seventh possible implementation manner of the first aspect, there is at least one processor in a soft processing group of the A soft processing groups, the soft processing group further includes a fourth delay unit, the fourth delay unit is hardwired to both the first delay unit and each processor, and the fourth delay unit is configured to: delay the first timing signal that is from the first delay unit, to obtain a fourth timing signal, and send the fourth timing signal to each processor; and
the processor is specifically configured to process the service data according to the control information in the first data packet under triggering of the fourth timing signal.

According to the first aspect, the first possible implementation manner of the first aspect, the second possible implementation manner of the first aspect, the third possible implementation manner of the first aspect, the fourth possible implementation manner of the first aspect, the fifth possible implementation manner of the first aspect, or the sixth possible implementation manner of the first aspect, in an eighth possible implementation manner of the first aspect, there is at least one processor in a soft processing group of the A soft processing groups, the soft processing group further includes a fourth delay unit and a timing scheduling unit, the fourth delay unit is hardwired to both the first delay unit and the timing scheduling unit, the timing scheduling unit is hardwired to each processor, the fourth delay unit is configured to: delay the first timing signal that is from the first delay unit, to obtain a fourth timing signal, and send the fourth timing signal to the timing scheduling unit, and the timing scheduling unit is configured to: delay the fourth timing signal that is from the fourth delay unit, to obtain a fifth timing signal, and send the fifth timing signal to each processor; and
the processor is specifically configured to process the service data according to the control information in the first data packet under triggering of the fifth timing signal.

According to the first aspect, the first possible implementation manner of the first aspect, the second possible implementation manner of the first aspect, the third possible implementation manner of the first aspect, the fourth possible implementation manner of the first aspect, the fifth possible implementation manner of the first aspect, the sixth possible implementation manner of the first aspect, the seventh possible implementation manner of the first aspect, or the eighth possible implementation manner of the first aspect, in a ninth possible implementation manner of the first aspect, the input interface is further configured to:
generate a service data packet within the n^{th} segment of a pre-determined period, and add the service data at a first data sampling rate to the service data packet, where the pre-determined period includes m coherent segments;
generate a control information packet within the n^{th} segment, and add the control information at a second data sampling rate to the control information packet;
obtain the n^{th} portion of the first data packet by adding the control information packet to the corresponding service data packet; and
send the first data packet to the processor, where
m is a positive integer, and n is a positive integer variable between 1 and m.

According to the first possible implementation manner of the first aspect, the second possible implementation manner of the first aspect, or the third possible implementation manner of the first aspect, in a tenth possible implementation manner of the first aspect, when i = 1, the first delay unit in the i^{th} processing group is a timing signal generation unit, and the timing signal generation unit is configured to generate the first timing signal.

According to the fourth possible implementation manner of the first aspect, the fifth possible implementation manner of the first aspect, or the sixth possible implementation manner of the first aspect, in an eleventh possible implementation manner of the first aspect, when i = 1, the third delay unit in the i^{th} processing group is a timing signal generation unit, and the timing signal generation unit is configured to generate the third timing signal.

Beneficial effects of the technical solutions provided by the embodiments of the present invention are as follows:

A soft processing group including a processor is disposed in a data processing system, so that service data involving a large quantity of operations in a processing process may be sent to the processor for processing. Because the processor has a relatively strong processing capability, a problem of low service data processing efficiency of a hardware system resulting from a relatively weak processing capability of a hard processing group is resolved, and service data processing efficiency is improved.

### BRIEF DESCRIPTION OF DRAWINGS

To describe the technical solutions in the embodiments of the present invention more clearly, the following briefly describes the accompanying drawings required for describing the embodiments. Apparently, the accompanying drawings in the following description show merely some embodiments of the present invention, and a person of ordinary skill in the art may still derive other drawings from these accompanying drawings without creative efforts.
FIG. 1 is a structural block diagram of a hardware system provided in the prior art;
FIG. 2 is a structural block diagram of a data processing system according to an embodiment of the present invention;
FIG. 3A is a structural block diagram of a data processing system according to another embodiment of the present invention;
FIG. 3B is a schematic diagram of first-type hardwiring of a processor according to another embodiment of the present invention;
FIG. 3C is a schematic diagram of second-type hardwiring of a processor according to another embodiment of the present invention;
FIG. 3D is a schematic diagram of first-type timing scheduling of a processor according to another embodiment of the present invention;
FIG. 3E is a schematic diagram of second-type timing scheduling of a processor according to another embodiment of the present invention;
FIG. 3F is a schematic diagram of synchronization/asynchronization delay according to another embodiment of the present invention; and
FIG. 3G is a schematic diagram of a data processing system according to another embodiment of the present invention.

### DESCRIPTION OF EMBODIMENTS

To make the objectives, technical solutions, and advantages of the present invention clearer, the following further describes the embodiments of the present invention in detail with reference to the accompanying drawings.

Referring to FIG. 2, FIG. 2 shows a structural block diagram of a data processing system provided in an embodiment of the present invention. The data processing system includes N cascaded processing groups. The N cascaded processing groups include A soft processing groups 210 and B hard processing groups 220, where A + B = N.

Each soft processing group 210 includes a first delay unit 211, an input interface 212, a processor 213, an output interface 214, and a second delay unit 215. The first delay unit 211 is hardwired to both the input interface 212 and the second delay unit 215. The processor 213 is electrically connected to both the input interface 212 and the output interface 214. The second delay unit 215 is hardwired to the output interface 214. The first delay unit 211 is configured to send a first timing signal to the input interface 212 and the second delay unit 215. The second delay unit 215 is configured to: delay the first timing signal that is from the first delay unit 211, to obtain a second timing signal, and send the second timing signal to the output interface 214. The input interface 212 is configured to: obtain service data, control information, and the first timing signal, combine the service data and the control information under triggering of the first timing signal to obtain a first data packet, and send the first data packet to the processor 213. The processor 213 is configured to: process the service data according to the control information in the first data packet, and send an obtained second data packet to the output interface 214, where the second data packet includes processed service data. The output interface 214 is configured to: parse the second data packet to obtain the processed service data, obtain the second timing signal, and output the processed service data under triggering of the second timing signal.

Each hard processing group 220 includes a third delay unit 221 and a hardware unit 222. The third delay unit 221 is hardwired to the hardware unit 222. The third delay unit 221 is configured to send a third timing signal to the hardware unit 222. N, A, and B are all positive integers.

In this embodiment, the processor 213 is a component that implements functions by executing code, and the functions implemented by the processor 213 may be changed by modifying code. Optionally, the processor 213 may include an algorithm unit and a memory. For example, the algorithm unit may be a central processing unit (CPU), a processor for implementing digital signal processing (DSP), or the like. The hardware unit 222 is a component that implements functions by using a circuit connection. After a circuit connection relationship is definite, the functions that can be implemented by the hardware unit 222 are definite. The processor 213 can identify a data packet, and the hardware unit 222 can send or receive service data by using a hardwire. Therefore, if data communication needs to be implemented between the processor 213 and the hardware unit 222, the input interface 212 and the output interface 214 further need to be respectively disposed before and after the processor 213. The input interface 212 is configured to obtain a data packet according to service data that is input by using a hardwire. The output interface 214 is configured to: parse the data packet to obtain the service data, and send, by using a hardwire, the service data obtained by means of parsing. The hardwire is a physical wire. The service data is data, in an intermediate frequency signal, for implementing a service.

In this embodiment, a delay unit may further be disposed in a processing group, and a timing signal generated by using the delay unit is used to control an output time point. In the soft processing group, the first delay unit 211 is configured to send the first timing signal to the input interface 212. The first timing signal is used to control an output time point of the input interface 212. The second delay unit 215 is configured to: delay the first timing signal that is from the first delay unit 211 by a pre-determined time length, and send the second timing signal obtained by means of delay to the output interface 214. The second timing signal is used to control an output time point of the output interface 214. The pre-determined time length is greater than or equal to a maximum time length for processing a data packet by the processor 213. In the hard processing group, the third delay unit 221 is configured to send the third timing signal to the hardware unit 222. The third timing signal is used to control an output time point of the hardware unit 222. The first timing signal may be generated by the first delay unit 211 or may be obtained by delaying a received timing signal by the first delay unit 211, and the third timing signal may be generated by the third delay unit 221 or may be obtained by delaying a received timing signal by the third delay unit 221. These are not limited in this embodiment.

The service data is data, in the intermediate frequency signal, for implementing a service. The control information is used to indicate a service data processing manner of a processor. For example, the control information is used to indicate an algorithm for the service data, or the control information is used to indicate a time point of an operation for the service data. The control information and the service data are synchronized. The processor 213 can identify a data packet, and the hardware unit 222 can send or receive service data by using a hardwire. Therefore, if data communication needs to be implemented between the processor 213 and the hardware unit 222, the input interface 212 further needs to be disposed before the processor 213. The input interface 212 is configured to combine the service data and the control information that are input by using a hardwire to obtain the first data packet. In this case, the first timing signal is used to indicate a time point at which the input interface 212 sends the first data packet.

In this embodiment, when a soft processing group is the 1^{st} processing group in the data processing system, the input interface 212, served as input of the data processing system, receives the service data and the control information. In this case, a first timing signal is generated by the first delay unit 211. When a soft processing group is not the 1^{st} processing group in the data processing system, the service data and the control information are generated by a previous processing group connected to the soft processing group. The processing group may be a soft processing group or a hard processing group. In this case, the first timing signal is obtained by the first delay unit 211 by delaying a timing signal sent by the previous processing group.

Similarly, when a hard processing group is the 1^{st} processing group in the data processing system, the hardware unit 222, served as input of the data processing system, receives the service data. In this case, the third timing signal is generated by the third delay unit 221. When a hard processing group is not the 1^{st} processing group in the data processing system, the service data is generated by a previous processing group connected to the hard processing group. The processing group may be a soft processing group or a hard processing group. In this case, the third timing signal is obtained by the third delay unit 221 by delaying a timing signal sent by the previous processing group.

In this embodiment, after receiving the first data packet, the processor 213 may start a data processing procedure under triggering of the first data packet. The processor 213 can process the first data packet in real time. Therefore, a time length for processing the first data packet is shortened, and service data processing efficiency is improved. Specifically, the processor 213 may read information, such as a packet validity signal, control information, and a packet number, from a control information packet. When determining that the packet validity signal is a pre-determined packet validity flag value, the processor 213 determines that the control information packet is valid and a service data packet corresponding to the control information packet has been stored in a specified storage area. The processor 213 obtains, from the specified storage area, the service data packet whose packet number is the same as that of the control information packet, reads service data from the service data packet, and processes the service data according to the control information. After processing the service data, the processor removes the packet validity signal. The processor 213 needs to complete processing of the first data packet within a fixed time period, and the fixed time length is a maximum time length for processing one first data packet by the processor 213.

After obtaining processed service data, the processor 213 may add the processed service data to the second data packet, and send the second data packet to the output interface 214; or may add the processed service data and the control information to the second data packet, and send the second data packet to the output interface 214. This is not limited in this embodiment. The second timing signal is used to indicate a time point at which the output interface 214 sends a processed service data packet, and may be obtained by the second delay unit 215 by delaying the first timing signal delay unit by a pre-determined time length. The pre-determined time length is greater than or equal to the maximum time length for processing the first data packet by the processor 213, so as to ensure that the output interface 214 can output the processed service data in the second data packet. The second timing signal is obtained by delaying the first timing signal. Therefore, a fixed delay time between the input interface 212 and the output interface 214 can be ensured, thereby ensuring a fixed total delay time of the data processing system.

In conclusion, according to the data processing system provided in this embodiment of the present invention, a soft processing group including a processor is disposed in the data processing system, so that service data involving a large quantity of operations in a processing process may be sent to the processor for processing. Because the processor has a relatively strong processing capability, a problem of low service data processing efficiency of a hardware system resulting from a relatively weak processing capability of a hard processing group is resolved, and service data processing efficiency is improved. In addition, a second delay unit triggers an output interface to output data, ensuring a fixed time length for processing service data by the soft processing group, and ensuring a fixed total delay time of the data processing system.

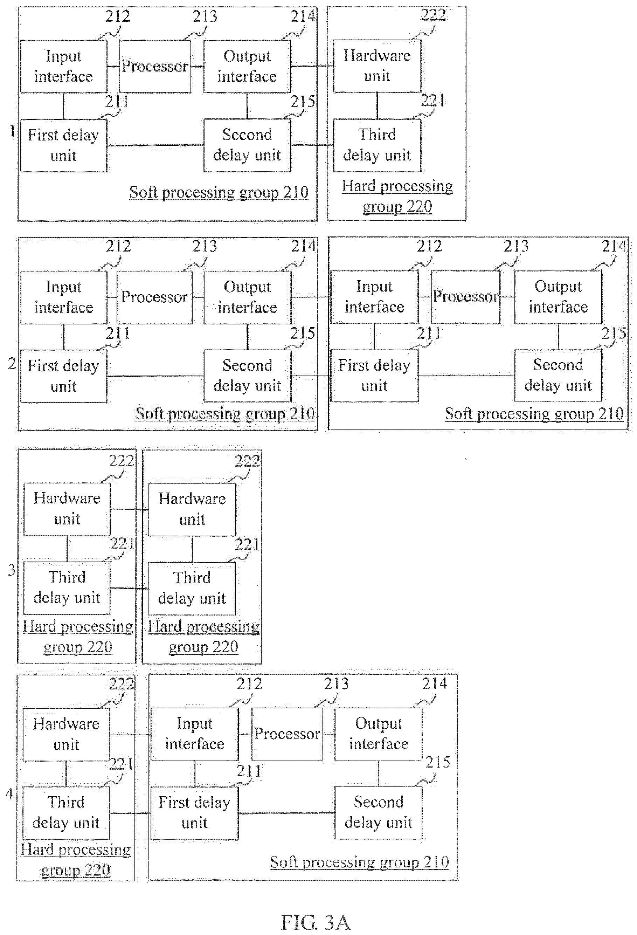

Based on the data processing system shown in FIG. 2, another embodiment of the present invention further provides a data processing system. Internal structures of a soft processing group and a hard processing group are different. Therefore, a cascade between a soft processing group and a hard processing group, a cascade between a soft processing group and a soft processing group, a cascade between a hard processing group and a soft processing group, and a cascade between a hard processing group and a hard processing group are all different. The following uses the i^{th} processing group and the (i+1)^{th} processing group as an example to detail the foregoing four cascading relationships, where i is a positive integer.
(1) Referring to the first figure in FIG. 3A, when the i^{th} processing group is a soft processing group and the (i+1)^{th} processing group is a hard processing group, an output interface 214 in the i^{th} processing group is hardwired to a hardware unit 222 in the (i+1)^{th} processing group, and a second delay unit 215 in the i^{th} processing group is hardwired to a third delay unit 221 in the (i+1)^{th} processing group. The output interface 214 in the i^{th} processing group outputs service data to the hardware unit 222 in the (i+1)^{th} processing group. The second delay unit 215 in the i^{th} processing group outputs a second timing signal to the third delay unit 221 in the (i+1)^{th} processing group.
(2) Referring to the second figure in FIG. 3A, when the i^{th} processing group is a soft processing group and the (i+1)^{th} processing group is a soft processing group, an output interface 214 in the i^{th} processing group is hardwired to an input interface 212 in the (i+1)^{th} processing group, and a second delay unit 215 in the i^{th} processing group is hardwired to a first delay unit 211 in the (i+1)^{th} processing group. The output interface 214 in the i^{th} processing group outputs service data to the input interface 212 in the (i+1)^{th} processing group. The second delay unit 215 in the i^{th} processing group outputs a second timing signal to the first delay unit 211 in the (i+1)^{th} processing group. According to the first-type cascading relationship and the second-type cascading relationship, when i = 1, the first delay unit 211 in the i^{th} processing group is a timing signal generation unit, and the timing signal generation unit is configured to generate a first timing signal. That is, when i = 1, the first delay unit 211 in the 1^{st} processing group generates a timing signal. In this case, the first delay unit 211 in the 1^{st} processing group may be referred to as the timing signal generation unit.
(3) Referring to the third figure in FIG. 3A, when the i^{th} processing group is a hard processing group and the (i+1)^{th} processing group is a hard processing group, a hardware unit 222 in the i^{th} processing group is hardwired to a hardware unit 222 in the (i+1)^{th} processing group, and a third delay unit 221 in the i^{th} processing group is hardwired to a third delay unit 221 in the (i+1)^{th} processing group. The hardware unit 222 in the i^{th} processing group outputs service data to the hardware unit 222 in the (i+1)^{th} processing group. The third delay unit 221 in the i^{th} processing group outputs a third timing signal to the third delay unit 221 in the (i+1)^{th} processing group.
(4) Referring to the fourth figure in FIG. 3A, when the i^{th} processing group is a hard processing group and the (i+1)^{th} processing group is a soft processing group, a hardware unit 222 in the i^{th} processing group is hardwired to an input interface 212 in the (i+1)^{th} processing group, and a third delay unit 221 in the i^{th} processing group is hardwired to a first delay unit 211 in the (i+1)^{th} processing group. The hardware unit 222 in the i^{th} processing group outputs service data to the input interface 212 in the (i+1)^{th} processing group. The third delay unit 221 in the i^{th} processing group outputs a third timing signal to the first delay unit 211 in the (i+1)^{th} processing group. According to the third cascading relationship and the fourth cascading relationship, when i = 1, the third delay unit 221 in the i^{th} processing group is a timing signal generation unit, and the timing signal generation unit is configured to generate a first timing signal. That is, when i = 1, the third delay unit 221 in the 1^{st} processing group generates a timing signal. In this case, the third delay unit 221 in the 1^{st} processing group may be referred to as the timing signal generation unit.

When processing service data according to the foregoing cascading relationships, a processor 213 needs to determine a service data processing manner according to control information, where the control information and the service data are synchronized. The synchronization between the control information and the service data means a sampling period of the service data is the same as that of the control information. Assuming that the sampling period of the service data includes P sampling points, the sampling period of the control information also includes the P sampling points. Therefore, the i^{th} processing group may sample a control signal, to obtain control information synchronous with service data, and send the control information and the service data together to the (i+1)^{th} soft processing group. Generally, a change frequency of the control signal is lower than that of the service data. Therefore, a sampling frequency of the control signal may be lower than that of the service data, so as to avoid redundant control information. A higher sampling frequency indicates higher precision of the control information. Correspondingly, a larger data volume in the control information results in more resources to be consumed for sending the control information. When a real-time requirement for the control information is not high, the foregoing method may be used to obtain the control information. In this case, the input interface 212 is further configured to: generate a service data packet within the n^{th} segment of a pre-determined period, and add the service data at a first data sampling rate to the service data packet, where the pre-determined period includes m coherent segments; generate a control information packet within the n^{th} segment, and add the control information at a second data sampling rate to the control information packet; obtain the n^{th} portion of the first data packet by adding the control information packet to the corresponding service data packet; and send the first data packet to the processor, where m is a positive integer, and n is a positive integer variable between 1 and m. Therefore, service data packets within all segments constitute a to-be-output service data packet.

In this embodiment, the first data packet may include a service data packet and a control data packet, and the control information packet is sent after the service data packet. Service data is added to the service data packet, and control information is added to the control data packet. Specifically, a control signal may be sampled within a pre-determined period, to obtain m control information packets. In this case, the pre-determined period includes m coherent segments. Within each segment, one service data packet and one control information packet are generated. A control information packet is added to a corresponding service data packet. One service data packet and one control information packet are served as one portion of the first data packet together. Assuming that m is 2, the first data packet sequentially includes: the 1^{st} service data packet, the 1^{st} control information packet, the 2^{nd} service data packet, and the 2^{nd} control information packet. The 1^{st} service data packet is obtained by sampling service data within the 1^{st} segment, and the 1^{st} control information packet is obtained by sampling a control signal within the 1^{st} segment. The 2^{nd} service data packet is obtained by sampling service data within the 2^{nd} segment, and the 2^{nd} control information packet is obtained by sampling a control signal within the 2^{nd} segment.

In a possible implementation manner, m = 1. In this case, the first data packet includes only one service data packet and one control information packet. Specifically, when a control signal is being sampled, and when the control signal is a pulse signal: if a rising edge exists in the control signal within a pre-determined period, the control information is set to 1; or if a rising edge does not exist in the control signal within a pre-determined period, the control information is set to 0. When the control signal is a level signal: if the control signal retains to a high level within a pre-determined period, the control information is set to 1; or if the control signal retains to a low level within a pre-determined period, the control information is set to 0. Certainly, the control signal may also be sampled in another manner, which is not limited in this embodiment.

When a real-time requirement for the control information is relatively high, to reduce resources consumed for transmitting the control information, the i^{th} processing group may directly send a control signal to a processor 213 in the (i+1)^{th} soft processing group by using a hardwire. In this case, the processor 213 in the (i+1)^{th} soft processing group further needs to obtain a timing signal sent by the i^{th} processing group, so as to generate, according to the timing signal, control information synchronous with service data. When the i^{th} processing group is a soft processing group, the timing signal is the second timing signal. When the i^{th} processing group is a hard processing group, the timing signal is the third timing signal. The following separately details a connection relationship, between the i^{th} processing group and the (i+1)^{th} processing group, existing when the i^{th} processing group is a soft processing group or when the i^{th} processing group is a hard processing group.

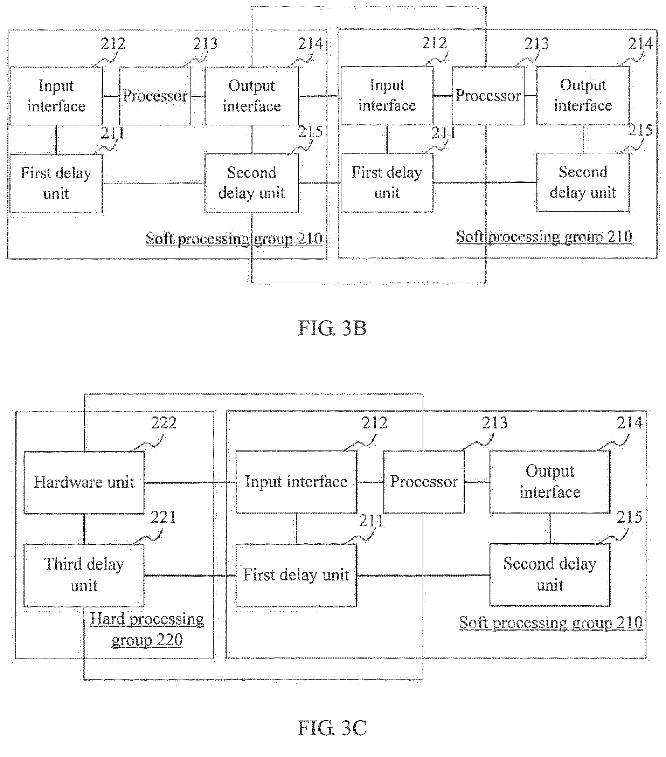

Referring to a schematic diagram of first-type hardwiring of a processor shown in FIG. 3B, when the i^{th} processing group is a soft processing group and the (i+1)^{th} processing group is a soft processing group, an output interface 214 in the i^{th} processing group is hardwired to a processor 213 in the (i+1)^{th} processing group, a second delay unit 215 in the i^{th} processing group is hardwired to the processor 213 in the (i+1)^{th} processing group. The processor 213 in the (i+1)^{th} processing group is configured to: generate control information according to a control signal from the output interface 214 in the i^{th} processing group and a second timing signal from the second delay unit 215 in the i^{th} processing group, and process service data from the output interface 214 in the i^{th} processing group according to the control information. The output interface 214 in the i^{th} processing group sends the control signal to the processor 213 in the (i+1)^{th} processing group. The second delay unit 215 in the i^{th} processing group sends the second timing signal to the processor 213 in the (i+1)^{th} processing group. The processor 213 in the (i+1)^{th} processing group generates the control information according to the control signal and the second timing signal, and process the service data according to the control information.

Referring to a schematic diagram of second-type hardwiring of a processor shown in FIG. 3C, when the i^{th} processing group is a hard processing group and the (i+1)^{th} processing group is a soft processing group, a hardware unit 222 in the i^{th} processing group is hardwired to a processor 213 in the (i+1)^{th} processing group, a third delay unit 221 in the i^{th} processing group is hardwired to the processor 213 in the (i+1)^{th} processing group. The processor 213 in the (i+1)^{th} processing group is configured to: generate control information according to a control signal from the hardware unit 222 in the i^{th} processing group and a third timing signal from the third delay unit 221 in the i^{th} processing group, and process service data from the hardware unit 222 in the i^{th} processing group according to the control information. The hardware unit 222 in the i^{th} processing group sends the control signal to the processor 213 in the (i+1)^{th} processing group. The third delay unit 221 in the i^{th} processing group sends the third timing signal to the processor 213 in the (i+1)^{th} processing group. The processor 213 in the (i+1)^{th} processing group generates the control information according to the control signal and the third timing signal, and process the service data according to the control information.

When the processor 213 is connected to a hardwire, an input interface 212 is further configured to: obtain service data and a first timing signal, combine the service data and the control information under triggering of the first timing signal to obtain a first data packet, and send the first data packet to the processor 213. The processor 213 is further configured to: obtain a control signal and the first timing signal, generate, according to the control signal and under triggering of the first timing signal, control information synchronous with the service data, process the service data in the first data packet according to the control information, and send an obtained second data packet to an output interface 214, where the second data packet includes processed service data. The output interface 214 is further configured to: parse the second data packet to obtain the processed service data, obtain a second timing signal, and output the processed service data under triggering of the second timing signal.

The input interface 212 is specifically configured to: generate a service data packet, add the service data at a pre-determined data sampling rate to the first data packet within a pre-determined period, and send the first data packet to the processor 213. The processor 213 is specifically configured to: obtain the pre-determined period, the pre-determined data sampling rate, and a generation time point of the first data packet, and sample the control signal at the pre-determined data sampling rate within the pre-determined period starting from the generation time point, to obtain the control information synchronous with the service data.

In this embodiment, the processor 213 needs to ensure that a process of sampling the control signal is synchronized with a process of sampling the service data by the input interface 212, so as to ensure complete synchronization between the generated control information and the service data. When synchronization sampling is performed, the processor 213 needs to obtain a sampling start time point, a sampling rate, and a sampling period that are of the service data. The sampling start time point is the generation time point of the first data packet. The sampling rate is the pre-determined data sampling rate. The sampling period is the pre-determined period. In this case, the processor 213 may sample, based on the generation time point, the control signal at the pre-determined data sampling rate within the pre-determined period, to obtain the control information.

Correspondingly, after the control information is obtained, the processor 213 may further generate a control information packet for the control information. A packet number of the control information packet is the same as a packet number of the first data packet. After receiving the first data packet, the processor 213 obtains the control information packet whose packet number is the same as that of the first data packet, and processes the first data packet according to the control information packet.

When a soft processing group of A soft processing groups includes one processor 213, the processor 213 is electrically connected to both an input interface 212 and an output interface 214. When a soft processing group of A soft processing groups includes at least two processors 213, any one of the processors 213 may be electrically connected to the other processors 213, and may be electrically connected to an input interfaced 212 or an output interface 214.

In this embodiment, the processor 213 may start a data processing process after obtaining a data packet. Alternatively, the processor 213 may start a data processing process under triggering of a timing signal, and in this case, the timing signal needs to be sent to the processor 213 by using a hardwire. In this embodiment, specifically, the timing signal is sent to the processor 213 by using a hardwire in the following two manners.

In a first possible implementation manner, there is at least one processor 213 in a soft processing group of the A soft processing groups. The soft processing group further includes a fourth delay unit 216. The fourth delay unit 216 is hardwired to both a first delay unit 211 and each processor 213. The fourth delay unit 216 is configured to: delay a first timing signal that is from the first delay unit 211, to obtain a fourth timing signal, and send the fourth timing signal to each processor 213. The processor 213 is specifically configured to process the service data according to the control information in the first data packet under triggering of the fourth timing signal.

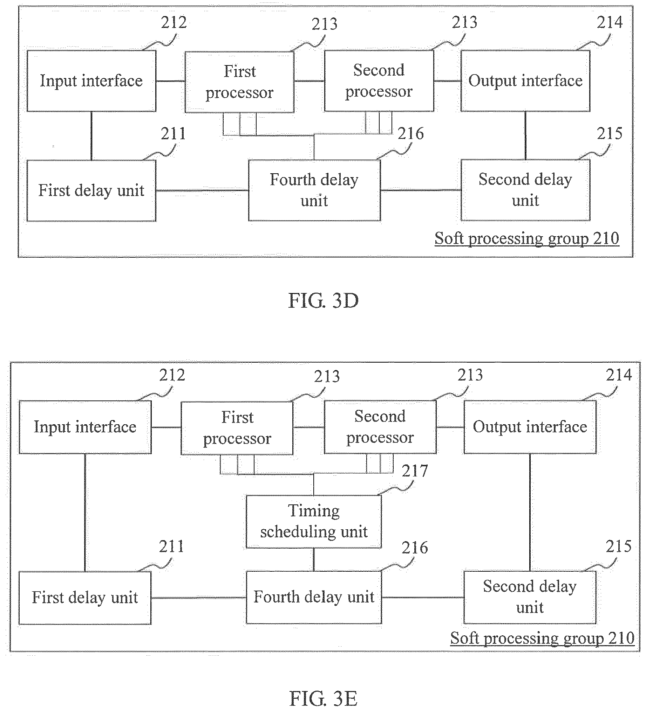

The first delay unit 211 sends the first timing signal to the fourth delay unit 216. The fourth delay unit 216 determines a delay time of each processor 213 according to a pre-determined policy, and after delaying the first timing signal by the corresponding delay time, sends the fourth timing signal obtained by means of delaying to the corresponding processor 213. The fourth timing signal is used to control a time point at which the corresponding processor 213 processes the first data packet. Referring to a schematic diagram of first-type timing scheduling of a processor shown in FIG. 3D, in FIG. 3D, an example in which a soft processing group 210 includes a first processor 213 and a second processor 213 is used for description.

For example, the soft processing group includes the first processor 213 and the second processor 213. A delay time corresponding to the first processor 213 is 10s, and a delay time corresponding to the second processor 213 is 20 seconds. Assuming that the first delay unit 211 sends the first timing signal at a time point 16:02:15, the fourth delay unit 216 determines that the fourth timing signal is to be sent to the first processor 213 at a time point 16:02:25, and that the fourth timing signal is to be sent to the second processor 213 at a time point 16:02:35.

It should be additionally noted that because a processor 213 may include at least two functional components, the fourth delay unit 216 may be hardwired to each functional component of the processor 213. For example, the processor 213 includes a CPU and a DSP, and the fourth delay unit 216 is connected to the CPU by using a hardwire and connected to the DSP by using another hardwire. If the functional components need to be controlled separately, at least two fourth timing signals need to be generated for the processor 213, and each fourth timing signal is sent, by using a corresponding hardwire, to a corresponding functional component of the processor 213.

Referring to a schematic diagram of second-type timing scheduling of a processor shown in FIG. 3E, in a second possible implementation manner, there is at least one processor 213 in a soft processing group of the A soft processing groups. The soft processing group further includes a fourth delay unit 216 and a timing scheduling unit 217. The fourth delay unit 216 is hardwired to both a first delay unit 211 and the timing scheduling unit 217. The timing scheduling unit 217 is hardwired to each processor 213. The fourth delay unit 216 is configured to: delay a first timing signal that is from the first delay unit 211, to obtain a fourth timing signal, and send the fourth timing signal to the timing scheduling unit 217. The timing scheduling unit 217 is configured to: delay the fourth timing signal that is from the fourth delay unit 216, to obtain a fifth timing signal, and send the fifth timing signal to each processor 213. The processor 213 is specifically configured to process the service data according to the control information in the first data packet under triggering of the fifth timing signal.

The first delay unit 211 sends the first timing signal to the fourth delay unit 216. After delaying the first timing signal, the fourth delay unit 216 sends the fourth timing signal obtained by means of delaying to the timing scheduling unit 217. The timing scheduling unit 217 determines a delay time of each processor 213 according to a pre-determined policy, and after delaying the fourth timing signal by the corresponding delay time, sends the fifth timing signal obtained by means of delaying to the corresponding processor 213. The fifth timing signal is used to control a time point at which the corresponding processor 213 processes the first data packet.

It should be additionally noted that because a processor 213 may include at least two functional components, the timing scheduling unit 217 may be hardwired to each functional component of the processor 213. For example, the processor 213 includes a CPU and a DSP, and the timing scheduling unit 217 is connected to the CPU by using a hardwire and connected to the DSP by using another hardwire. If the functional components need to be controlled separately, at least two fifth timing signals need to be generated for the processor 213, and each fifth timing signal is sent, by using a corresponding hardwire, to a corresponding functional component of the processor 213.

There is the fourth delay unit 216. Therefore, in one implementation manner, a second delay unit 215 is connected to the first delay unit 211, and a time length for which the second delay unit 215 delays the first timing signal that is sent by the first delay unit 211 is greater than a time length for which the fourth delay unit 216 delays the first timing signal that is sent by the first delay unit 211. In another implementation manner, a second delay unit 215 is connected to the fourth delay unit 216, and delays the fourth timing signal that is sent by the fourth delay unit 216.

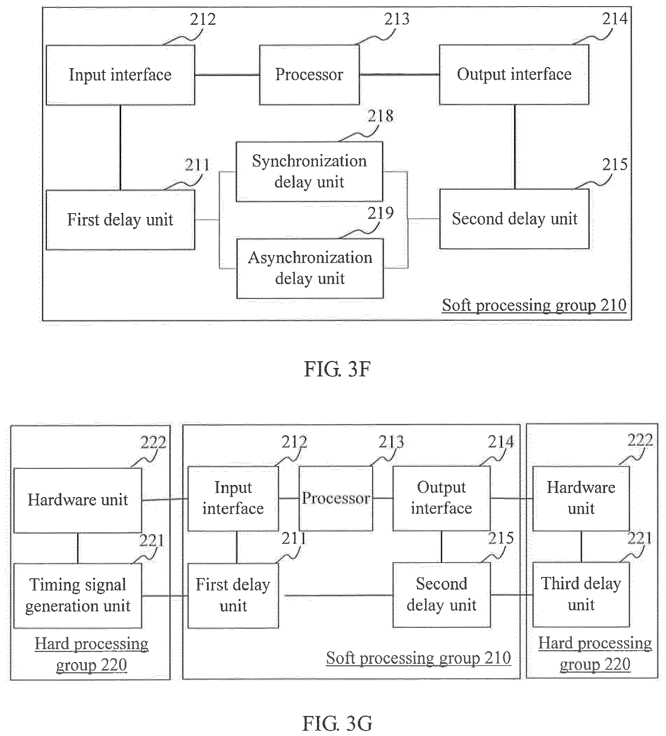

Referring to a schematic diagram of synchronization/asynchronization delay shown in FIG. 3F, when frequencies of clock sources used by the first delay unit 211 and the second delay unit 215 are the same, the first delay unit 211 sends a first timing signal to a synchronization delay unit 218. The synchronization delay unit 218 sends a first timing signal obtained after synchronization processing to the second delay unit 215. When frequencies of clock sources used by the first delay unit 211 and the second delay unit 215 are different, that is, the first delay unit 211 and the second delay unit 215 are asynchronous, the first delay unit 211 sends a first timing signal to an asynchronization delay unit 219. The asynchronization delay unit 219 sends a first timing signal obtained after asynchronization processing to the second delay unit 215. This ensures that the data processing system is free of variation after the data processing system is powered on. The synchronization delay unit 218 and the asynchronization delay unit 219 both can be implemented by using the prior art, and details are not described herein. Similarly, the synchronization delay unit 218 and the asynchronization delay unit 219 can also be used for a delay between the first delay unit 211 and the fourth delay unit 216, and details are not described herein.

Referring to a schematic diagram of a data processing system shown in FIG. 3G, in FIG. 3G, a hard processing group 220, a soft processing group 210, and a hard processing group 220 that are sequentially connected are included. A third delay unit 221 in the 1^{st} hard processing group 220 is a timing signal generation unit 221.

In conclusion, according to the data processing system provided in this embodiment of the present invention, a soft processing group including a processor is disposed in the data processing system, so that service data involving a large quantity of operations in a processing process may be sent to the processor for processing. Because the processor has a relatively strong processing capability, a problem of low service data processing efficiency of a hardware system resulting from a relatively weak processing capability of a hard processing group is resolved, and service data processing efficiency is improved. In addition, a second delay unit triggers an output interface to output data, ensuring a fixed time length for processing service data by the soft processing group, and ensuring a fixed total delay time of the data processing system. In addition, a control signal and a timing signal are sent to a processor by using a hardwire, and the processor generates, according to the control signal and the timing signal, control information synchronous with service data. This not only meets a real-time requirement for the control information, but also reduces resources consumed for sending the control information.

The sequence numbers of the foregoing embodiments of the present invention are merely for illustrative purposes, and are not intended to indicate priorities of the embodiments. A person of ordinary skill in the art may understand that all or some of the steps of the embodiments may be implemented by hardware or a program instructing related hardware. The program may be stored in a computer-readable storage medium. The storage medium may include: a read-only memory, a magnetic disk, or an optical disc. The foregoing descriptions are merely exemplary embodiments of the present invention, but are not intended to limit the present invention.

## Claims

1. A data processing system, wherein the system comprises N cascaded processing groups, the N cascaded processing groups comprise A soft processing groups and B hard processing groups, and A + B = N, wherein
each soft processing group (220) comprises a first delay unit (211), an input interface (212), a processor (213), an output interface (214), and a second delay unit (215); the first delay unit (211) is hardwired to both the input interface (212) and the second delay unit (215); the processor (213) is electrically connected to both the input interface (212) and the output interface (214); the second delay unit (215) is hardwired to the output interface (214); the first delay unit (211) is configured to send a first timing signal to the input interface (212) and the second delay unit (215); the second delay unit (215) is configured to: delay the first timing signal that is from the first delay unit (211), to obtain a second timing signal, and send the second timing signal to the output interface (214); the input interface (212) is configured to: obtain service data, control information, and the first timing signal, combine the service data and the control information under triggering of the first timing signal to obtain a first data packet, and send the first data packet to the processor (213); the processor (213) is configured to: process the service data according to the control information in the first data packet, and send an obtained second data packet to the output interface (214), wherein the second data packet comprises the processed service data; and
the output interface (214) is configured to: parse the second data packet to obtain the processed service data, obtain the second timing signal, and output the processed service data under triggering of the second timing signal;
each hard processing group (220) comprises a third delay unit (221) and a hardware unit, (222) the third delay unit (221) is hardwired to the hardware unit (222), and the third delay unit (221) is configured to generate a third timing signal or to obtain a third timing signal by delaying a timing signal sent by a previous processing group, and to send the third timing signal to the hardware unit (222), and the hardware unit (222) is configured to receive service data and to output the service data; and
N, A, and B are all positive integers.

2. The system according to claim 1, wherein
when the i^{th} processing group is a soft processing group and the (i+1)^{th} processing group is a hard processing group, an output interface in the i^{th} processing group is hardwired to a hardware unit in the (i+1)^{th} processing group, and a second delay unit in the i^{th} processing group is hardwired to a third delay unit in the (i+1)^{th} processing group, wherein i is a positive integer.

3. The system according to claim 1, wherein
when the i^{th} processing group is a soft processing group and the (i+1)^{th} processing group is a soft processing group, an output interface in the i^{th} processing group is hardwired to an input interface in the (i+1)^{th} processing group, and a second delay unit in the i^{th} processing group is hardwired to a first delay unit in the (i+1)^{th} processing group, wherein i is a positive integer.

4. The system according to claim 3, wherein the output interface in the i^{th} processing group is hardwired to a processor in the (i+1)^{th} processing group, the second delay unit in the i^{th} processing group is hardwired to the processor in the (i+1)^{th} processing group, and the processor in the (i+1)^{th} processing group is configured to: generate control information according to a control signal from the output interface in the i^{th} processing group and a second timing signal from the second delay unit in the i^{th} processing group, and process service data from the output interface in the i^{th} processing group according to the control information.

5. The system according to claim 1, wherein
when the i^{th} processing group is a hard processing group and the (i+1)^{th} processing group is a hard processing group, a hardware unit in the i^{th} processing group is hardwired to a hardware unit in the (i+1)^{th} processing group, and a third delay unit in the i^{th} processing group is hardwired to a third delay unit in the (i+1)^{th} processing group, wherein i is a positive integer.

6. The system according to claim 1, wherein
when the i^{th} processing group is a hard processing group and the (i+1)^{th} processing group is a soft processing group, a hardware unit in the i^{th} processing group is hardwired to an input interface in the (i+1)^{th} processing group, and a third delay unit in the i^{th} processing group is hardwired to a first delay unit in the (i+1)^{th} processing group, wherein i is a positive integer.

7. The system according to claim 6, wherein the hardware unit in the i^{th} processing group is hardwired to a processor in the (i+1)^{th} processing group, the third delay unit in the i^{th} processing group is hardwired to the processor in the (i+1)^{th} processing group, and the processor in the (i+1)^{th} processing group is configured to: generate control information according to a control signal from the hardware unit in the i^{th} processing group and a third timing signal from the third delay unit in the i^{th} processing group, and process service data from the hardware unit in the i^{th} processing group according to the control information.

8. The system according to any one of claims 1 to 7, wherein there is at least one processor in a soft processing group of the A soft processing groups, the soft processing group further comprises a fourth delay unit, the fourth delay unit is hardwired to both the first delay unit and each processor, and the fourth delay unit is configured to: delay the first timing signal that is from the first delay unit, to obtain a fourth timing signal, and send the fourth timing signal to each processor; and
the processor is specifically configured to process the service data according to the control information in the first data packet under triggering of the fourth timing signal.

9. The system according to any one of claims 1 to 7, wherein there is at least one processor in a soft processing group of the A soft processing groups, the soft processing group further comprises a fourth delay unit and a timing scheduling unit, the fourth delay unit is hardwired to both the first delay unit and the timing scheduling unit, the timing scheduling unit is hardwired to each processor, the fourth delay unit is configured to: delay the first timing signal that is from the first delay unit, to obtain a fourth timing signal, and send the fourth timing signal to the timing scheduling unit, and the timing scheduling unit is configured to: delay the fourth timing signal that is from the fourth delay unit, to obtain a fifth timing signal, and send the fifth timing signal to each processor; and
the processor is specifically configured to process the service data according to the control information in the first data packet under triggering of the fifth timing signal.

10. The system according to any one of claims 1 to 9, wherein the input interface is further configured to:
generate a service data packet within the n^{th} segment of a pre-determined period, and add the service data at a first data sampling rate to the service data packet, wherein the pre-determined period comprises m coherent segments;
generate a control information packet within the n^{th} segment, and add the control information at a second data sampling rate to the control information packet;
obtain the n^{th} portion of the first data packet by adding the control information packet to the corresponding service data packet; and
send the first data packet to the processor, wherein
m is a positive integer, and n is a positive integer variable between 1 and m.

11. The system according to any one of claims 2 to 4, wherein when i = 1, the first delay unit in the i^{th} processing group is a timing signal generation unit, and the timing signal generation unit is configured to generate the first timing signal.

12. The system according to any one of claims 5 to 7, wherein when i = 1, the third delay unit in the i^{th} processing group is a timing signal generation unit, and the timing signal generation unit is configured to generate the third timing signal.

## Patentansprüche

1. Datenverarbeitungssystem, wobei das System N kaskadierte Verarbeitungsgruppen umfasst, wobei die N kaskadierten Verarbeitungsgruppen A Soft-Verarbeitungsgruppen und B harte Verarbeitungsgruppen umfassen, und A + B = N, wobei
jede Soft-Verarbeitungsgruppe (220) eine erste Verzögerungseinheit (211), eine Eingangsschnittstelle (212), einen Prozessor (213), eine Ausgangsschnittstelle (214) und eine zweite Verzögerungseinheit (215) umfasst;
die erste Verzögerungseinheit (211) mit sowohl der Eingangsschnittstelle (212) als auch der zweiten Verzögerungseinheit (215) festverdrahtet ist;
der Prozessor (213) elektrisch sowohl mit der Eingangsschnittstelle (212) als auch der Ausgangsschnittstelle (214) verbunden ist;
die zweite Verzögerungseinheit (215) mit der Ausgangsschnittstelle (214) festverdrahtet ist;
die erste Verzögerungseinheit (211) zum Senden eines ersten Taktsignals an die Eingangsschnittstelle (212) und die zweite Verzögerungseinheit (215) konfiguriert ist;
die zweite Verzögerungseinheit (215) konfiguriert ist zum: Verzögern des ersten Taktsignals, das von der ersten Verzögerungseinheit (211) kommt, um ein zweites Taktsignal zu erhalten, und Senden des zweiten Taktsignals an die Ausgangsschnittstelle (214);
die Eingangsschnittstelle (212) konfiguriert ist zum: Erhalten von Dienstdaten, Steuerinformationen und des ersten Taktsignals, Kombinieren der Dienstdaten und der Steuerinformationen unter Triggerung des ersten Taktsignals, um ein erstes Datenpaket zu erhalten, und Senden des ersten Datenpakets an den Prozessor (213);
der Prozessor (213) konfiguriert ist zum: Verarbeiten der Dienstdaten gemäß den Steuerinformationen in dem ersten Datenpaket und Senden eines erhaltenen zweiten Datenpakets an die Ausgangsschnittstelle (214),
wobei das zweite Datenpaket die verarbeiteten Dienstdaten umfasst; und die Ausgangsschnittstelle (214) konfiguriert ist zum: Parsen des zweiten Datenpakets, um die verarbeiteten Dienstdaten zu erhalten, Erhalten des zweiten Taktsignals, und Ausgeben der verarbeiteten Dienstdaten unter Triggerung des zweiten Taktsignals;
jede harte Verarbeitungsgruppe (220) eine dritte Verzögerungseinheit (221) und eine Hardwareeinheit (222) umfasst, wobei die dritte Verzögerungseinheit (221) mit der Hardwareeinheit (222) festverdrahtet ist, und die dritte Verzögerungseinheit (221) konfiguriert ist zum Erzeugen eines dritten Taktsignals oder Erhalten eines dritten Taktsignals durch Verzögerung eines Taktsignals, das von einer vorherigen Verarbeitungsgruppe gesendet wurde, und zum Senden des dritten Taktsignals an die Hardwareeinheit (222), und die Hardwareeinheit (222) konfiguriert ist zum Empfangen der Dienstdaten und zum Ausgeben der Dienstdaten; und
N, A und B alle positive ganze Zahlen sind.

2. System nach Anspruch 1, wobei
wenn die i-te Verarbeitungsgruppe eine Soft-Verarbeitungsgruppe ist und die (i+1)-te Verarbeitungsgruppe eine harte Verarbeitungsgruppe ist, eine Ausgangsschnittstelle in der i-ten Verarbeitungsgruppe mit einer Hardwareeinheit in der (i+1)-ten Verarbeitungsgruppe festverdrahtet ist und eine zweite Verzögerungseinheit in der i-ten Verarbeitungsgruppe mit einer dritten Verzögerungseinheit in der (i+1)-ten Verarbeitungsgruppe festverdrahtet ist, wobei i eine positive ganze Zahl ist.

3. System nach Anspruch 1, wobei
wenn die i-te Verarbeitungsgruppe eine Soft-Verarbeitungsgruppe ist und die (i+1)-te Verarbeitungsgruppe eine Soft-Verarbeitungsgruppe ist, eine Ausgangsschnittstelle in der i-ten Verarbeitungsgruppe mit einer Eingangsschnittstelle in der (i+1)-ten Verarbeitungsgruppe festverdrahtet ist, und eine zweite Verzögerungseinheit in der i-ten Verarbeitungsgruppe mit einer ersten Verzögerungseinheit in der (i+1)-ten Verarbeitungsgruppe festverdrahtet ist, wobei i eine positive ganze Zahl ist.

4. System nach Anspruch 3, wobei die Ausgangsschnittstelle in der i-ten Verarbeitungsgruppe mit einem Prozessor in der (i+1)-ten Verarbeitungsgruppe festverdrahtet ist, wobei die zweite Verzögerungseinheit in der i-ten Verarbeitungsgruppe mit dem Prozessor in der (i+1)-ten Verarbeitungsgruppe festverdrahtet ist, und der Prozessor in der (i+1)-ten Verarbeitungsgruppe konfiguriert ist zum: Erzeugen von Steuerinformationen gemäß einem Steuersignal von der Ausgangsschnittstelle in der i-ten Verarbeitungsgruppe und einem zweiten Taktsignal von der zweiten Verzögerungseinheit in der i-ten Verarbeitungsgruppe und Verarbeiten von Dienstdaten von der Ausgangsschnittstelle in der i-ten Verarbeitungsgruppe gemäß den Steuerinformationen.

5. System nach Anspruch 1, wobei
wenn die i-te Verarbeitungsgruppe eine harte Verarbeitungsgruppe ist und die (i+1)-te Verarbeitungsgruppe eine harte Verarbeitungsgruppe ist, eine Hardwareeinheit in der i-ten Verarbeitungsgruppe mit einer Hardwareeinheit in der (i+1)-ten Verarbeitungsgruppe festverdrahtet ist, und eine dritte Verzögerungseinheit in der i-ten Verarbeitungsgruppe mit einer dritten Verzögerungseinheit in der (i+1)-ten Verarbeitungsgruppe festverdrahtet ist, wobei i eine positive ganze Zahl ist.

6. System nach Anspruch 1, wobei
wenn die i-te Verarbeitungsgruppe eine harte Verarbeitungsgruppe ist und die (i+1)-te Verarbeitungsgruppe eine Soft-Verarbeitungsgruppe ist, eine Hardwareeinheit in der i-ten Verarbeitungsgruppe mit einer Eingangsschnittstelle in der (i+1)-ten Verarbeitungsgruppe festverdrahtet ist, und eine dritte Verzögerungseinheit in der i-ten Verarbeitungsgruppe mit einer ersten Verzögerungseinheit in der (i+1)-ten Verarbeitungsgruppe festverdrahtet ist, wobei i eine positive ganze Zahl ist.

7. System nach Anspruch 6, wobei die Hardwareeinheit in der i-ten Verarbeitungsgruppe mit einem Prozessor in der (i+1)-ten Verarbeitungsgruppe festverdrahtet ist, wobei die dritte Verzögerungseinheit in der i-ten Verarbeitungsgruppe mit dem Prozessor in der (i+1)-ten Verarbeitungsgruppe festverdrahtet ist, und der Prozessor in der (i+1)-ten Verarbeitungsgruppe konfiguriert ist zum: Erzeugen von Steuerinformationen gemäß einem Steuersignal von der Hardwareeinheit in der i-ten Verarbeitungsgruppe und einem dritten Taktsignal von der dritten Verzögerungseinheit in der i-ten Verarbeitungsgruppe und Verarbeiten von Dienstdaten von der Hardwareeinheit in der i-ten Verarbeitungsgruppe gemäß den Steuerinformationen.

8. System nach einem der Ansprüche 1 bis 7, wobei mindestens ein Prozessor in einer Soft-Verarbeitungsgruppe der A Soft-Verarbeitungsgruppen vorhanden ist, wobei die Soft-Verarbeitungsgruppe ferner eine vierte Verzögerungseinheit umfasst, wobei die vierte Verzögerungseinheit sowohl mit der ersten Verzögerungseinheit als auch mit jedem Prozessor festverdrahtet ist, und die vierte Verzögerungseinheit konfiguriert ist zum: Verzögern des ersten Taktsignals, das von der ersten Verzögerungseinheit kommt, um ein viertes Taktsignal zu erhalten, und Senden des vierten Taktsignals an jeden Prozessor; und
der Prozessor speziell konfiguriert ist zum Verarbeiten der Dienstdaten gemäß den Steuerinformationen in dem ersten Datenpaket unter Triggerung des vierten Taktsignals.

9. System nach einem der Ansprüche 1 bis 7, wobei mindestens ein Prozessor in einer Soft-Verarbeitungsgruppe der A Soft-Verarbeitungsgruppen vorhanden ist, wobei die Soft-Verarbeitungsgruppe ferner eine vierte Verzögerungseinheit und eine Takt-Scheduling-Einheit umfasst, die vierte Verzögerungseinheit sowohl mit der ersten Verzögerungseinheit als auch mit der Takt-Scheduling-Einheit festverdrahtet ist, wobei die Takt-Scheduling-Einheit mit jedem Prozessor festverdrahtet ist, wobei die vierte Verzögerungseinheit konfiguriert ist zum: Verzögern des ersten Taktsignals, das von der ersten Verzögerungseinheit kommt, um ein viertes Taktsignal zu erhalten, und Senden des vierten Taktsignals an die Takt-Scheduling-Einheit, und die Takt-Scheduling-Einheit konfiguriert ist zum: Verzögern des vierten Taktsignals, das von der vierten Verzögerungseinheit kommt, um ein fünftes Taktsignal zu erhalten, und Senden des fünften Taktsignals an jeden Prozessor; und
der Prozessor speziell konfiguriert ist zum Verarbeiten der Dienstdaten gemäß den Steuerinformationen in dem ersten Datenpaket unter Triggerung des fünften Taktsignals.

10. System nach einem der Ansprüche 1 bis 9, wobei die Eingangsschnittstelle ferner konfiguriert ist zum:
Erzeugen eines Dienstdatenpakets innerhalb des n-ten Segments einer vorbestimmten Periode und Hinzufügen der Dienstdaten mit einer ersten Datenabtastrate zu dem Dienstdatenpaket, wobei die vorbestimmte Periode m kohärente Segmente umfasst;
Erzeugen eines Steuerinformationspakets innerhalb des n-ten Segments und Hinzufügen der Steuerinformationen mit einer zweiten Datenabtastrate zu dem Steuerinformationspaket;
Erhalten des n-ten Segments des ersten Datenpakets durch Hinzufügen des Steuerinformationspakets zu dem entsprechenden Dienstdatenpaket; und
Senden des ersten Datenpakets an den Prozessor, wobei
m eine positive ganze Zahl ist, und n eine positive ganze Zahl, variabel zwischen 1 und m, ist.

11. System nach einem der Ansprüche 2 bis 4, wobei, wenn i = 1, die erste Verzögerungseinheit in der i-ten Verarbeitungsgruppe eine Taktsignalerzeugungseinheit ist, und die Taktsignalerzeugungseinheit zum Erzeugen des ersten Taktsignals konfiguriert ist.

12. System nach einem der Ansprüche 5 bis 7, wobei, wenn i = 1, die dritte Verzögerungseinheit in der i-ten Verarbeitungsgruppe eine Taktsignalerzeugungseinheit ist und die Taktsignalerzeugungseinheit zum Erzeugen des dritten Taktsignals konfiguriert ist.

## Revendications

1. Système de traitement de données, le système comprenant N groupes de traitement en cascade, les N groupes de traitement en cascade comprenant A groupes de traitement logiciels et B groupes de traitement matériels, et A+ B = N, et dans lequel :
chaque groupe de traitement logiciel (220) comprend une première unité de retard (211), une interface d'entrée (212), un processeur (213), une interface de sortie (214) et une deuxième unité de retard (215) ;
la première unité de retard (211) est câblée à la fois à l'interface d'entrée (212) et à la deuxième unité de retard (215) ;
le processeur (213) est connecté électriquement à la fois à l'interface d'entrée (212) et à l'interface de sortie (214) ;
la deuxième unité de retard (215) est câblée à l'interface de sortie (214) ;
la première unité de retard (211) est configurée pour envoyer un premier signal de synchronisation à l'interface d'entrée (212) et à la deuxième unité de retard (215) ;
la deuxième unité de retard (215) est configurée pour : retarder le premier signal de synchronisation en provenance de la première unité de retard (211), afin d'obtenir un deuxième signal de synchronisation, et envoyer le deuxième signal de synchronisation à l'interface de sortie (214) ;
l'interface d'entrée (212) est configurée pour : obtenir des données de service, des informations de contrôle et le premier signal de synchronisation, combiner les données de service et les informations de contrôle au déclenchement du premier signal de synchronisation afin d'obtenir un premier paquet de données, et envoyer le premier paquet de données au processeur (213) ;
le processeur (213) est configuré pour: traiter les données de service selon les informations de contrôle dans le premier paquet de données, et envoyer un second paquet de données obtenu à l'interface de sortie (214), le second paquet de données comprenant les données de service traitées ; et
l'interface de sortie (214) est configurée pour : analyser le second paquet de données afin d'obtenir les données de service traitées, obtenir le deuxième signal de synchronisation, et émettre les données de service traitées au déclenchement du deuxième signal de synchronisation ;
chaque groupe de traitement matériel (220) comprend une troisième unité de retard (221) et une unité matérielle (222), la troisième unité de retard (221) est câblée à l'unité matérielle (222), et la troisième unité de retard (221) est configurée pour générer un troisième signal de synchronisation ou pour obtenir un troisième signal de synchronisation en retardant un signal de synchronisation envoyé par un groupe de traitement précédent, et pour envoyer le troisième signal de synchronisation à l'unité matérielle (222), et l'unité matérielle (222) est configurée pour recevoir des données de service et pour émettre les données de service ; et
N, A et B sont tous des entiers positifs.

2. Système selon la revendication 1, dans lequel :
quand le i^{ème} groupe de traitement est un groupe de traitement logiciel et le (i+1)^{ème} groupe de traitement est un groupe de traitement matériel, une interface de sortie du i^{ème} groupe de traitement est câblée à une unité matérielle du (i+1)^{ème} groupe de traitement, et une deuxième unité de retard du i^{ème} groupe de traitement est câblée à une troisième unité de retard du (i+1)^{ème} groupe de traitement, i étant un entier positif.

3. Système selon la revendication 1, dans lequel :
quand le i^{ème} groupe de traitement est un groupe de traitement logiciel et le (i+1)^{ème} groupe de traitement est un groupe de traitement logiciel, une interface de sortie du i^{ème} groupe de traitement est câblée à une interface d'entrée du (i+1)^{ème} groupe de traitement, et une deuxième unité de retard du i^{ème} groupe de traitement est câblée à une première unité de retard du (i+1)^{ème} groupe de traitement, i étant un entier positif.

4. Système selon la revendication 3, dans lequel l'interface de sortie du i^{ème} groupe de traitement est câblée à un processeur du (i+1)^{ème} groupe de traitement, la deuxième unité de retard du i^{ème} groupe de traitement est câblée au processeur du (i+1)^{ème} groupe de traitement, et le processeur du (i+1)^{ème} groupe de traitement est configuré pour : générer des informations de contrôle selon un signal de contrôle en provenance de l'interface de sortie du i^{ème} groupe de traitement et un deuxième signal de synchronisation en provenance de la deuxième unité de retard du i^{ème} groupe de traitement, et traiter des données de service en provenance de l'interface de sortie du i^{ème} groupe de traitement selon les informations de contrôle.

5. Système selon la revendication 1, dans lequel :
quand le i^{ème} groupe de traitement est un groupe de traitement matériel et le (i+1)^{ème} groupe de traitement est un groupe de traitement matériel, une unité matérielle du i^{ème} groupe de traitement est câblée à une unité matérielle du (i+1)^{ème} groupe de traitement, et une troisième unité de retard du i^{ème} groupe de traitement est câblée à une troisième unité de retard du (i+1)^{ème} groupe de traitement, i étant un entier positif.

6. Système selon la revendication 1, dans lequel :
quand le i^{ème} groupe de traitement est un groupe de traitement matériel et le (i+1)^{ème} groupe de traitement est un groupe de traitement logiciel, une unité matérielle du i^{ème} groupe de traitement est câblée à une interface d'entrée du (i+1)^{ème} groupe de traitement, et une troisième unité de retard du i^{ème} groupe de traitement est câblée à une première unité de retard du (i+1)^{ème} groupe de traitement, i étant un entier positif.

7. Système selon la revendication 6, dans lequel l'unité matérielle du i^{ème} groupe de traitement est câblée à un processeur du (i+1)^{ème} groupe de traitement, la troisième unité de retard du i^{ème} groupe de traitement est câblée au processeur du (i+1)^{ème} groupe de traitement, et le processeur du (i+1)^{ème} groupe de traitement est configuré pour : générer des informations de contrôle selon un signal de contrôle en provenance de l'unité matérielle du i^{ème} groupe de traitement et un troisième signal de synchronisation en provenance de la troisième unité de retard du i^{ème} groupe de traitement, et traiter des données de service en provenance de l'unité matérielle du i^{ème} groupe de traitement selon les informations de contrôle.

8. Système selon l'une quelconque des revendications 1 à 7, dans lequel il y a au moins un processeur dans un groupe de traitement logiciel des A groupes de traitement logiciels, le groupe de traitement logiciel comprend en outre une quatrième unité de retard, la quatrième unité de retard est câblée à la fois à la première unité de retard et à chaque processeur, et la quatrième unité de retard est configurée pour : retarder le premier signal de synchronisation en provenance de la première unité de retard, afin d'obtenir un quatrième signal de synchronisation, et envoyer le quatrième signal de synchronisation à chaque processeur ; et
le processeur est spécifiquement configuré pour traiter les données de service selon les informations de contrôle dans le premier paquet de données au déclenchement du quatrième signal de synchronisation.

9. Système selon l'une quelconque des revendications 1 à 7, dans lequel il y a au moins un processeur dans un groupe de traitement logiciel des A groupes de traitement logiciels, le groupe de traitement logiciel comprend en outre une quatrième unité de retard et une unité de planification de synchronisation, la quatrième unité de retard est câblée à la fois à la première unité de retard et à l'unité de planification de synchronisation, l'unité de planification de synchronisation est câblée à chaque processeur, la quatrième unité de retard est configurée pour :
retarder le premier signal de synchronisation en provenance de la première unité de retard, afin d'obtenir un quatrième signal de synchronisation, et envoyer le quatrième signal de synchronisation à l'unité de planification de synchronisation, et l'unité de planification de synchronisation est configurée pour : retarder le quatrième signal de synchronisation en provenance de la quatrième unité de retard, afin d'obtenir un cinquième signal de synchronisation, et envoyer le cinquième signal de synchronisation à chaque processeur ; et
le processeur est spécifiquement configuré pour traiter les données de service selon les informations de contrôle dans le premier paquet de données au déclenchement du cinquième signal de synchronisation.

10. Système selon l'une quelconque des revendications 1 à 9, dans lequel l'interface d'entrée est en outre configurée pour :
générer un paquet de données de service dans le n^{ième} segment d'une période prédéterminée, et ajouter les données de service à un premier taux d'échantillonnage de données au paquet de données de service, la période prédéterminée comprenant m segments cohérents ;
générer un paquet d'informations de contrôle dans le n^{ième} segment, et ajouter les informations de contrôle à un second taux d'échantillonnage de données au paquet d'informations de contrôle ;
obtenir la n^{ième} partie du premier paquet de données en ajoutant le paquet d'informations de contrôle au paquet de données de service correspondant ; et
envoyer le premier paquet de données au processeur,
m étant un entier positif, et n étant un entier positif variable entre 1 et m.

11. Système selon l'une quelconque des revendications 2 à 4, dans lequel, quand i = 1, la première unité de retard du i^{ème} groupe de traitement est une unité de génération de signal de synchronisation, et l'unité de génération de signal de synchronisation est configurée pour générer le premier signal de synchronisation.

12. Système selon l'une quelconque des revendications 5 à 7, dans lequel, quand i = 1, la troisième unité de retard du i^{ème} groupe de traitement est une unité de génération de signal de synchronisation, et l'unité de génération de signal de synchronisation est configurée pour générer le troisième signal de synchronisation.
